# EUROPEAN PATENT APPLICATION

(11) **EP 3 564 790 A1**
(43) Date of publication of application: **06.11.2019**
(21) Application number: 16924994.3
(22) Date of filing: 29.12.2016
(51) Int. Cl.: G06F 3/02, G09F 9/30, H01R 35/00

(54) **FLEXIBLE ELECTRONIC DEVICE**

(71) Applicant: Shenzhen Royole Technologies Co., Ltd., Shenzhen, Guangdong 518172 (CN)
(72) Inventor: ZHANG, Qiang, Shenzhen Guangdong 518052 (CN); WANG, Chaogang, Shenzhen Guangdong 518052 (CN)
(74) Representative: Mewburn Ellis LLP
(86) International application number: PCT/CN2016/112975
(87) International publication number: WO 2018/119857

(57) **Abstract**

A flexible electronic apparatus includes a housing (10), a roller (40) received in the housing (10), and a main body (100) wound around the roller (40). The roller (40) is coupled to an end cover (20) provided with a functional component (24). The roller (40) is rotated relative to the end cover (20) to expand or retract the main body (100). The end cover (20) is provided with conductive rails (25) electrically coupled to the functional component (24). The roller (40) is provided with conductive terminals (26) corresponding to the conductive rails (25). The conductive terminals (26) are slidably connected to the conductive rails (25) and slide along the conductive rails (25) as the roller (40) rotates.

## Description

### TECHNICAL FIELD

The present disclosure relates to the technology field of terminal devices, and more particularly relates to a flexible electronic apparatus.

### BACKGROUND

Electronic apparatuses, such as mobile phones, PDAs, and notebooks, are widely used in life. Users generally operate the electronic apparatuses via touch screens or external keyboards. With development of high technology, the users are increasingly demanding the portability and diversity of electronic apparatuses. Existing rollable electronic apparatuses generally include a roll that drives flexible functional components to rotate and end covers disposed at ends of the roll. The end covers are generally provided with functional devices that are electrically coupled to the flexible functional components. The end covers remain stationary to ensure normal operations of the functional devices when the flexible functional components rotate. When the roller rotates and the end covers remain stationary, how to ensure a stable electrical coupling between the roller and the end cover is a problem that skill in art have been seeking to solve.

### SUMMARY

Embodiments of the present disclosure provide a flexible electronic apparatus with a stable electrical coupling.

An embodiment of the present disclosure provides a flexible electronic apparatus. The flexible electronic apparatus includes a housing, an end cover provided with a functional component and including a number of conductive rails electrically coupled to the functional component; a roller received in the housing and connected to the end cover, and a main body being operable to be wound around the roller or released from the roller. The roller is provided with a number of conductive terminals corresponding to the conductive rails. The conductive terminals slide along the conductive rails as the roller rotates.

In an embodiment, the roller includes a control module disposed therein, and the conductive terminals are coupled to the control module via wires.

In an embodiment, each conductive terminal includes a seat and a conductive post fixed to the seat. The conductive post includes an end portion, a head portion, and a flange protruding from a circumferential surface of the conductive post. The end portion is electronically coupled to the wires, and a distal end of the head portion slidably contacts with the conductive rail.

In an embodiment, the seat includes a through hole defined therein for receiving the end portion of the conductive terminal. The flange is limited in the through hole. The head portion extends out of the through hole.

In an embodiment, the seat includes a first ferrule and a second ferrule which is formed at one end of the first ferrule and coaxial with the first ferrule. The through hole extends through the first ferrule and the second ferrule. An end of the roller is provided with an end plate. The end plate defines a terminal slot. The terminal slot includes a first portion and a second portion formed at one end of the first portion. The seat is fixed in the terminal slot. The first ferrule is received in the first portion. The second ferrule is received in the second portion.

In an embodiment, a diameter of the end portion is larger than that of the head portion. A step is formed in the through hole of the seat to engage with the flange.

In an embodiment, an external circumferential wall of the second ferrule is chamfered, and an internal circumferential wall of the second portion of the terminal slot is accordingly chamfered.

In an embodiment, an inner wall of the first portion of the terminal slot is provided with a first stop surface, and an external wall of the first ferrule of the seat is provided with a second stop surface. The first stop surface engages the second stop surface to restrict a rotation of the first ferrule.

In an embodiment, a wall of the end cover is provided with a recess. The conductive rails are received in the recess. Each conductive rail comprises a rail table formed in the recess and a conductive ring formed on a surface of the rail table.

In an embodiment, each rail table is further provided with a number of inserting slot, each conductive rail is provided with a number conductive leads. The conductive leads are inserted into the inserting slots to electrically couple to the functional component.

In an embodiment, the end cover is further provided with a resetting conductive rail, the roller is further provided with a conductive terminal corresponding to the resetting conductive rail. A rail table is further provided in the recess for supporting the resetting conductive rail. The rail tables are coaxially and spaced from each other.

In an embodiment, the number of the conductive terminals is two, one is a positive electrode, and the other is a negative electrode.

In an embodiment, the flexible electronic apparatus further includes a driving member. The driving member includes a motor and a rotating shaft which is rotatable relative to the motor. The motor is fixed to the roller, and the rotating shaft is fixed to the end cover.

In an embodiment, the conductive rails surround the rotating shaft.

In an embodiment, the functional component is a connector and the end cover is provided with a cavity and a port communicated with the cavity. The connector includes a circuit board and a socket fixed to the circuit board. The circuit board is received in the cavity, and the socket corresponds to the port.

In an embodiment, the end cover includes a limiting member, and a limiting recess is formed in an internal wall of the cavity for receiving the limiting member therein. The limiting member is axially restricted, and the rotating shaft is inserted into the limiting member and is axially restricted.

In an embodiment, a bottom wall of the limiting recess is provided with a through hole communicated with the limiting recess. The limiting member includes a base plate and a sleeve protruding from the base plate. The sleeve is inserted into the through hole, and the sleeve defines a limiting hole. The rotating shaft is inserted into the limiting hole.

In an embodiment, the roller includes a first shell and a second shell separable from the first shell. The first shell is attached to the second shell, and a motor of the driving member is received a receiving space cooperatively defined by the first shell and the second shell and fixed to the first shell and the second shell.

In the present disclosure, the flexible electronic apparatus drives the conductive terminals to slide along the conductive rails disposed at the second end cover by rotating the roller to realize the electrical coupling between the connector and the control module, which neither affects the rotation of the roller nor affects the electrical coupling between the connector and the control module, thereby ensuring the coupling stability between the connector and the control module.

### BRIEF DESCRIPTION OF THE DRAWINGS

To better illustrate the technical solutions of embodiments of the present disclosure, the following descriptions will briefly illustrate the accompanying drawings described in the embodiments. Obviously, the following described accompanying drawings are merely some embodiments of the present disclosure. Those skilled in the art may obtain other accompanying drawings according to the described accompanying drawings without creative efforts.
FIG. 1 is a structural schematic view of a flexible electronic apparatus according to an embodiment of the present disclosure.
FIG. 2 is an exploded schematic view of part of the flexible electronic apparatus illustrated in FIG. 1.
FIG. 3 is an exploded schematic view of a roller of the flexible electronic apparatus illustrated in FIG. 2.
FIG. 4 is a structural schematic view of a first shell of the roller illustrated in FIG. 3.
FIG. 5 is a structural schematic view of a second shell of the roller illustrated in FIG. 3.
FIG. 6 is a structural schematic view of a driving member of the flexible electronic apparatus illustrated in FIG. 3.
FIG. 7 is an exploded schematic view of part of a second shell of the roller illustrated in FIG. 3.
FIG. 8 is an exploded schematic view of a first end cover and a switch of the flexible electronic apparatus illustrated in FIG. 2, which illustrates a roller.
FIG. 9 is an exploded schematic view of a button of the switch and the first end cover illustrated in FIG. 8, but viewed from another aspect.
FIG. 10 is a partial exploded schematic view of a second end cover of the flexible electronic apparatus illustrated in FIG. 2, which illustrates a roller and a driving member.
FIG. 11 is a partial cross-sectional view of the second end cover illustrated in FIG. 10.
FIG. 12 is a cross-sectional view of a second end cover illustrated in FIG. 2 attached to a roller, which illustrates a connector attached to the second end cover.
FIG. 13 and FIG. 14 are schematic exploded views of one type of electrical connections between a connector illustrated in FIG. 2 and electronic components disposed in a roller.
FIG. 15 is a schematic exploded view of a conductive terminal illustrated in FIG. 13.
FIG. 16 is a schematic cross-sectional view of the flexible electronic apparatus having electrical connections illustrated in FIG. 13.
FIG. 17 is a schematic exploded views of another type of electrical connections between a connector of the flexible electronic apparatus illustrated in FIG. 1 and electronic components disposed in a roller.
FIG. 18 is a structural schematic view of a first shell of the flexible electronic apparatus illustrated in FIG. 17.
FIG. 19 is a cross-sectional view of a second end cover of the flexible electronic apparatus illustrated in FIG. 17.
FIG. 20 is a cross-sectional view of a second end cover and a connector of the flexible electronic apparatus illustrated in FIG. 17.
FIG. 21 is a schematic cross-sectional view of the flexible electronic apparatus illustrated in FIG. 17.

### DETAILED DESCRIPTION OF ILLUSTRATED EMBODIMENTS

The technical solutions of embodiments of the present disclosure will be described clearly and completely in combination with the accompanying drawings of the embodiments of the present disclosure.

Embodiments of the present disclosure provide a flexible electronic apparatus. The flexible electronic apparatus may be a rollable touch keyboard with a flexible touch panel, a flexible display screen, or a combination of a flexible keyboard and a flexible display, which may be used for, but not limited to, a mobile phone, a tablet computer, a palmtop computer, a personal digital assistant (PDA), an e-reader, or the like, not specifically limited in the embodiments of the present disclosure.

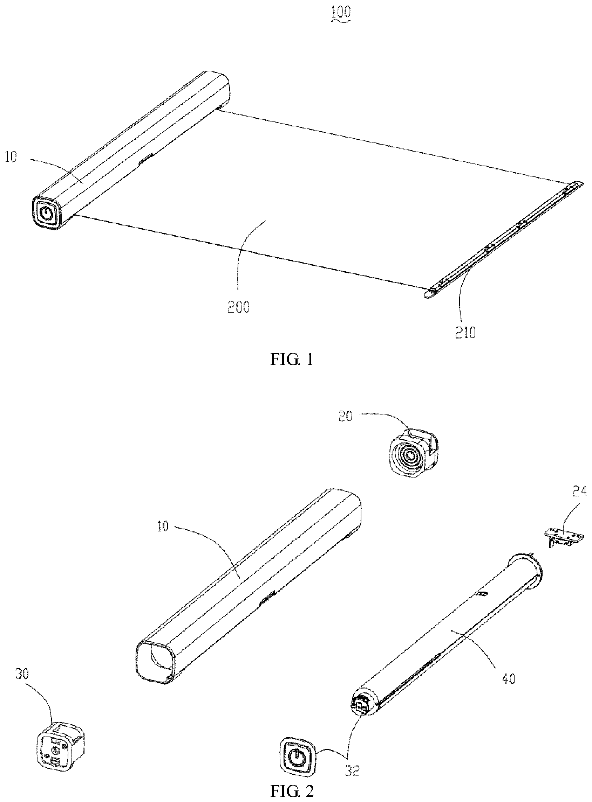

As illustrated in FIG. 1, FIG. 2, and FIG. 3, in the embodiment, the flexible electronic apparatus 100 is roll-type and includes a housing 10, a roller 40 received in the housing 10, and a main body 200 of the flexible electronic apparatus 100 capable of winding around the roller 40, a driving member 70, a battery 80, and a control module 90. The control module 90, the battery 80, and the driving member 70 are spaced apart from each other and disposed in the roller 40. The battery 80 and the driving member 70 are electrically coupled to the control module 90. The battery 80 is disposed between the control module 90 and the driving member 70. The driving member 70 drives the roller 40 to rotate relative to the housing 10. The main body 200 may retract into the housing 10 via a rotation of the roller 40, or extend from the housing 10. In the embodiment, the driving member 70 is disposed in the roller 40 which acts as a rotating shaft of the main body and rotates as the roller rotates 40, thereby saving a space occupied by rotating structures of the roller and effectively reducing the overall length of the housing.

A first end of the main body 200 extends out of the housing 10 such that the main body 200 may be drawn out of the roller 40. A second end of the main body 200 is fixed in the roller 40. The first end of the main body 200 is provided with a pull rod 210. The housing 10 is provided with a through slot, and the pull rod 210 is retained in the through slot. The driving member drives the roller 40 to rotate such that the main body 200 is wound around the roller 40 or released from the roller 40. The main body 200 is electronically coupled to the control module 90 through a flexible circuit board. The control module 90 includes a circuit board and a number of electronic components disposed on the circuit board. The housing 10 is a hollow sleeve with two openings provided at two opposite ends of the sleeve. The housing 10 may be integrally formed or assembled by two parts. The roller is attached to the housing 10 through end portions, and the housing is covered by end plates or end covers.

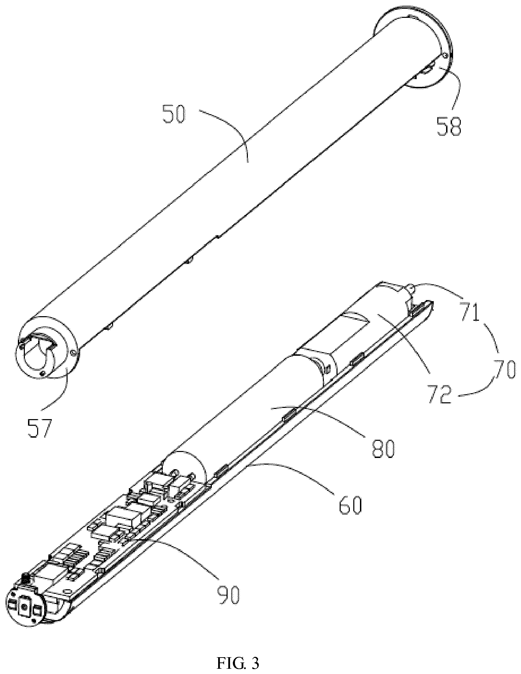

As illustrated in FIG. 3, FIG. 4 and FIG. 5, in the embodiment, the roller 40 is a hollow tube and includes a first shell 50 and a second shell 60 separable from the first shell 50. The first shell 50 is capable of being attached to the second shell 60. The driving member 70 is received in a receiving space cooperatively defined by the first shell 50 and the second shell 60 and attached to the first shell 50 and the second shell 60. The first shell 50 and the second shell 60 are semicircular structures. The first shell 50 defines a first space 51 therein and the second shell 60 defines a second space 61 defined therein. The first space 51 includes a pair of spaced first posts 54 protruding from a bottom wall thereof. The second space 61 includes a pair of spaced second posts 64 protruding from a bottom wall thereof. The first posts 54 may be inserted in the second posts 64. Each of the first posts 54 and the second posts 64 defines a through hole therein for pins extending therethrough to fix the first posts 54 and the second posts 64.

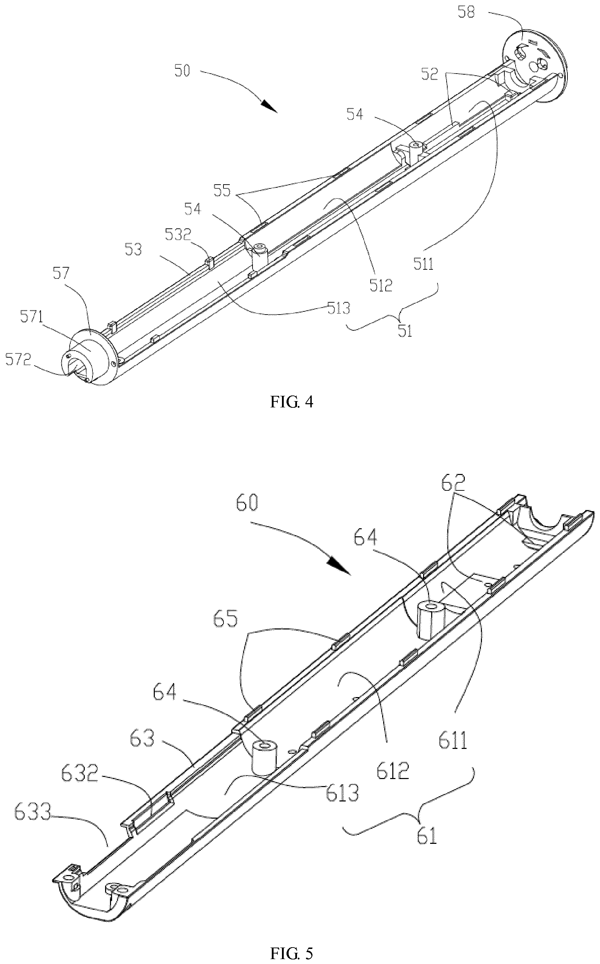

As illustrated in FIG. 4 and FIG. 5, the first space 51 and the second space 61 cooperatively define the receiving space. The receiving space is divided into three portions by the engagement of the first posts 54 with the second posts 64, for respectively receiving the control module 90, the battery 80, and the driving member 70 therein. The control module 90, the battery 80, and the driving member 70 are all attached to the first shell 50 and the second shell 60. In particular, the first posts 54 separate the first space 51 into a first portion 511 for receiving the driving member, a second portion 512 for receiving the battery, and a third portion 513 for receiving the control module. The second posts 64 separate the second space 61 into a first portion 611 for the driving member, a second portion 612 for receiving the battery, and a third portion 613 for receiving the control module. The first portion 511 and the first portion 611 cooperatively define a space to receive the control module 90 therein. The second portion 512 and the second portion 612 cooperatively define a space to receive the battery 80 therein. The third portion 513 and the third portion 613 cooperatively define a space to receive the driving member 70 therein. For the battery 80 being the heaviest among the battery 80, the control module 90, and the driving member 70, the battery 80 is disposed between the control module 90 and the battery 80, that is, the battery 80 is disposed in a middle portion of the roller, which is helpful to balance the roller.

In the embodiment, two opposite sides of the first shell 50 are provided with a pair of first avoidance platforms 53 facing the control module 90. Two opposite sides of the second shell 60 are provided with a pair of second avoidance platforms 63 corresponding to the first avoidance platforms 53. The first avoidance platforms 53 and the second avoidance platforms 63 cooperate to clamp the circuit board of the control module 90. In particular, the first avoidance platforms 53 are disposed at the two opposite sides of the first shell 50 adjacent to one end of the first shell 50 defining the first space 51, and the second avoidance platforms 63 are disposed at the two opposite sides of the second shell 60 adjacent to one end of the second shell 50 defining the second space 61. The first avoidance platforms 53 are further provided with a number of positioning members 532. When the first shell 50 is attached to the second shell 60 and the control module 90 is received in the receiving space, the first avoidance platforms 53 and the second avoidance platforms 63 cooperate to clamp the circuit board of the control module 90 therebetween. The circuit board of the control module 90 is further positioned by the positioning members 532. In addition, the second shell 60 further defines a slot 632 for receiving electronic components of the control module 90 and a cutout 633 for a circuit board of the main body 200 extending therethrough adjacent to the second avoidance platforms 63. The circuit board may extend into the roller 40 via the first avoidance platforms 53 and the second avoidance platforms 63, which reduces the receiving space of the roller occupied by the circuit board, makes the overall structure of the flexible electronic apparatus more compact, and reduces the volume of the flexible electronic apparatus.

As illustrated in FIG. 4 and FIG. 5, the first shell 50 includes a number of first latching members and the second shell 60 includes a number of second latching members engaging with the first latching members. In this embodiment, the first latching members include a number of latching slots 55 defined in the opposite sides of the first shell 50, and the second latching members includes a number of latching blocks 65 extending from the opposite sides of the second shell 60 adjacent another end of the second shell 60. When the first shell 50 mates with the second shell 60, the latching blocks 65 engage in the latching slot 55, the first avoidance platforms 53 face the second avoidance platforms 63, the first posts 54 engage with the second posts 64 and are fixed by the pins. Thus, the first shell 50 is fixedly attached to the second shell 60. In other embodiments, the first latching members may be latching blocks and the second latching members may be latching slots. In other embodiments, the first latching members and the second latching members may be magnets.

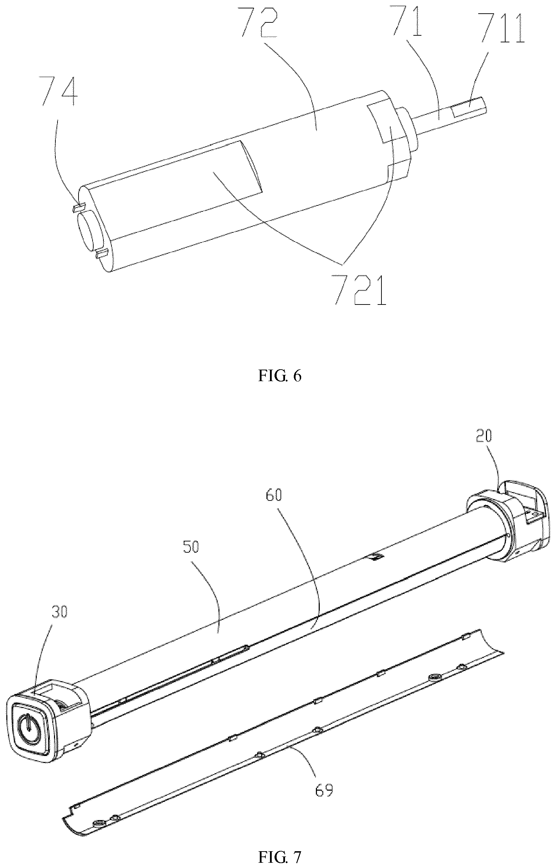

As illustrated in FIG. 6, the driving member 70 includes a motor 72, and a rotating shaft 71 rotatably attached to one end of the motor 72. Another end of the motor 72 is provided with a pair of conductive pins 74 configured to be electrically coupled to the control module 90. The motor 72 includes two pairs of limiting walls 721 formed at an external circumferential surface thereof with planes, which are formed by cutting off portions of peripheral walls of the motor 72. The first shell 50 is provided two first limiting blocks 52 formed at the inner wall of the first shell 50 and the second shell 60 is provided two second limiting blocks 62 formed at the inner wall of the second shell 60. The first limiting blocks 52 and the second limiting blocks 62 engage with the limiting walls 721 to fix the motor in the roller 40. In the embodiment, the first limiting blocks 52 and the second limiting blocks 62 are located in the first portion for receiving the driving member therein, the first limiting blocks 52 are spaced from each other, the second limiting blocks 62 are spaced from each other, and the first limiting blocks 52 and the second limiting blocks 62 correspond to the limiting walls 721.

As illustrated in FIG. 7, an external cover 69 is further provided to be attached to an external surface of the second shell 60. The external surface of the second shell 60 is provided with a number of clamping holes defined in the external surface of the second shell 60. The external cover 69 is correspondingly provided with a number of clamps for engaging in the clamping holes to fix the external cover 69 to the second shell 60. Fasteners further extend through the external cover 69 to engage in the external surface of the second shell 60 to further fix the external cover 69 and the second shell 60. The external cover 69 is configured to sandwich the second end of the main body 200 together with the external surface to fix the main body 200 to the inner housing. In other embodiments, the second end of the main body may be fixed to the inner housing by adhesives.

As illustrated in FIG. 2, FIG. 4, and FIG. 5, in one embodiment of the present disclosure, the roller 40 is sealed in housing 10 by end covers. To improve the performance of the roller, the flexible electronic apparatus further includes switches and functional components disposes at the end covers. One end of the first shell 50 is provided with a first end plate and the other end of the first shell 50 is provided with a second end plate. The first end plate and the second end plate are respectively located at two opposite ends of the first space 51.In the embodiment, one end of the first shell 50 is provided with a first end plate 57 and another end of the first shell 50 is provided with a second end plate 58. The first end plate 57 and the second end plate 58 are respectively located at two opposite ends of the first space 51. Two opposite ends of the second shell 60 are provided with two opening for respectively receiving the first end plate 57 and the second end plate 58. The flexible electronic apparatus includes a first end cover 30 and a second end cover 20. The first end cover 30 is attached to the first end plate 57 and the second end cover 20 is attached to the second end plate 58. The two opposite ends of the housing 10 are sealed by the first end cover 30 and the second end cover 20, and fixed to the first end cover 30 and the second end cover 20. The first end cover 30 is provided with a switch 32 electronically coupled to the control module 90 and configured to control the start of the roller 40 and the functional implementation of the main body 200. The functional components disposed on the second end cover 20 is a connector 24 configured to charge the battery 80 and transmit data of the main body 200.

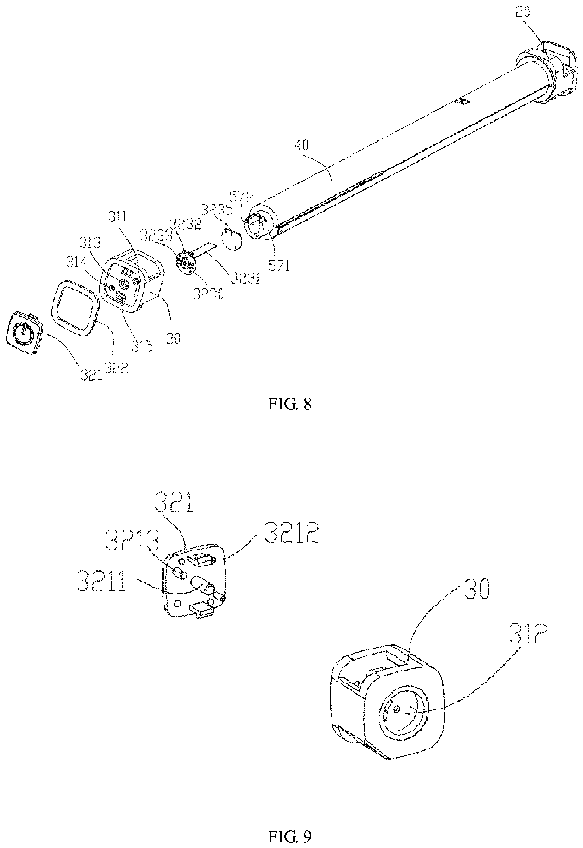

As illustrated in FIG. 8 and FIG. 9, an external surface of the first end plate 57 is provided with a protruding ring 571. The protruding ring 571 axially defines a through hole 572 which extends through the first end plate 57 and is communicated the receiving space. The first end cover 30 is substantially a hollow block. A first end wall of the first end cover 30 is provided with a mounting recess 311 and a second end wall of the first end cover 30 opposite to the first end wall is provided with an opening 312. The protruding ring 571 extends into and is fixed in the opening 312 such that the first end cover 30 is attached to the roller.

As illustrated in FIG. 8 and FIG. 9, the switch includes a contact and a button. The button is movably attached to an external surface of the first end cover for touching the contact. In particular, the switch 32 includes a button 321 and a flexible circuit board 323 with a contact 3232. The flexible circuit board 323 extends through the first end plate to be received in the first end cover and the receiving space. The button 321 is attached to the first end wall of the first end cover 30. A center of a pressing wall of the button 321 is provided with a rod 3211 with a spring sleeved thereon, a pair of hooks 3212, and a pair of pins 3213 beside the rod 3211. A bottom wall of the mounting recess 311 includes a through hole 313 for the rod 3211 extending therethrough, a pair of slot 315 for engaging with the hooks 3212, and a pair of through holes 314 for engaging with the pins 3213. The button 321 is movably mounted in the mounting recess 311. A gasket 322 is disposed between the button 321 and the mounting recess 311 for tightly attaching the button 321 to the first end cover 30.

The flexible circuit board 323 further includes a board body 3230 provided with the contact 3232 and a light source 3233, and an extension tab 3231 extending from the board body 3230. The extension tab 3231 is bended from the board body 3230. The board body 3230 is received in the opening 312 and supported and fixed on the protruding ring 571 via a supporting tab 3235. The extension tab 3231 of the flexible circuit board 323 away from the board body 3230 extends through the through slot 572 of the protruding ring to be coupled with the control module 90. The button 321 is movably mounted in the mounting recess 311. The rod 3211 of the button 321 extends through the opening 312 to abut against or move away from the contact 3232 to activate the function of the switch, and the spring provides elasticity to the button 321. The light source 3233 provides a backlight for the button 321.

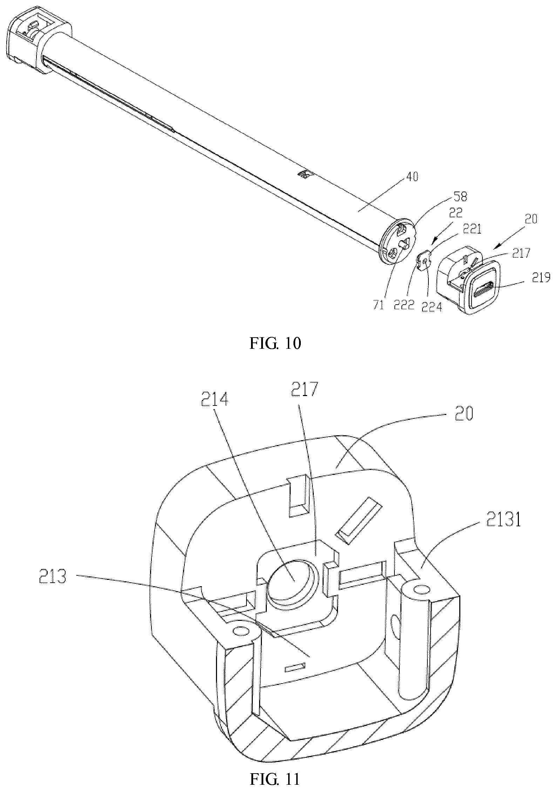

As illustrated in FIGS. 10 to 14, the second end cover 20 is fixed to the second end plate 58. The second end cover 20 is substantially a hollow block and includes a first plate 211, a second plate 212 parallel to the first plate 211, a cavity 213 defined between the first plate 211 and the second plate 212, and a limiting member 22 fixed in the cavity. A port 219 for accessing the connector 24 is define in the first plate 211 and is communicated with the cavity 213. A mounting wall is formed at a side of the second plate 212 through which the second end cover 20 is attached to the second end plate 58. The motor is fixed in the roller, the rotating shaft 71 is inserted into the second end cover 20 and is axially restricted relative to the second end cover 20. When the motor drives the roller to rotate, the rotating shaft, the housing, and the second end cover remain stationary. The roller 40 rotates relative to the second end cover 20 as the motor 72 rotates.

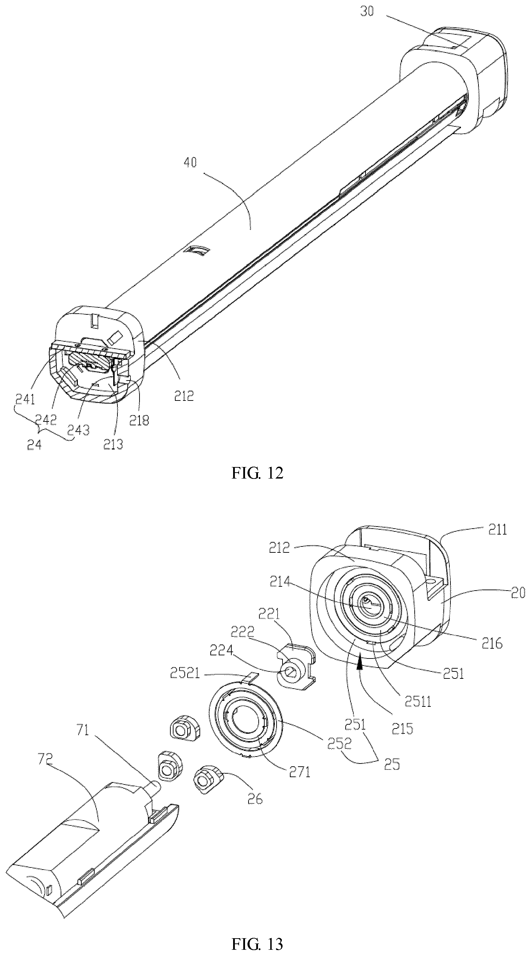

As illustrated in FIG. 13, the limiting member 22 includes a base plate 221 and a sleeve 222 protruding from the base plate 221. The base plate 221 is non-rotationally symmetrical. A limiting through hole 224 is defined in the sleeve 222. The rotating shaft 71 of the driving member 70 extends through the second end plate to be fixed in the limiting through hole 224. As illustrated in FIG. 6, a first flat wall 711 is formed at an external surface of the rotating shaft 71. A second flat wall is formed at an internal wall of the limiting through hole 224 for engaging with the first flat wall 711 to restrict a rotation of the rotating shaft 71. The cavity 213 includes an inner wall adjacent to the mounting wall and disposed opposite to the mounting wall. A limiting recess 217 is defined in the inner wall. The limiting member 22 is received in the limiting recess 217 and is axially restricted. A contour of the limiting recess 217 is the same as a contour of the base plate 221 of the limiting member. The base plate 221 is provided with a limiting structure to engage with a limiting structure of the limiting recess 217, such that the base plate 221 is restricted in the limiting recess 217 and is incapable of rotating. A through hole 214 is defined in a bottom wall of the limiting recess 217 and extends through the second plate 212, for the sleeve 222 extending therethrough. The second plate 212 is attached to the second end plate 58 via the first mounting wall. The rotating shaft 71 of the motor 72 extends through the second end cover 58 to insert into the limiting through hole 224 of the sleeve 222 to be fixed. In the embodiment, the connector 24 and the control module transmit signals in a wired connection manner or a wireless connection manner.

As illustrated in FIG. 12, the connector 24 includes a circuit board 241, a socket 242 fixed to the circuit board 241, and a resilient member 243. The connector 24 is disposed in the cavity 213. The socket 242 includes an interface facing the port 219. The socket 242 and the resilient member 243 are fixed to a surface of the circuit board 241. The resilient member 243 is located at one end of the circuit board 24 and perpendicular to the circuit board 241. A pair of steps is formed in the cavity 213 beside the limiting member 22 for supporting the circuit board 241. The socket 242 and the resilient member 243 are covered by the circuit board 241. Furthermore, a through hole 218 is define in a sidewall of the cavity 213 to implement a reset function.

It should be understood that the roller 40 may be directly sealed in the housing 10 through the end plates. In particular, one end of the first shell 50 is provided with a first end plate (not illustrated), and the other end of the first shell 50 is provided with a second end plate. In this embodiment, the first end plate and the second end plate both are flat plates. When the roller 40 is mounted in the housing 10, the first end plate and the second end plate are attached to opposite ends of the housing 10 to seal the roller in the housing 10. It should be understood that, an external surface of the first end plate and an external surface of the second plate may be provided with decorations (not illustrated). The space for receiving the driving member in the first shell 50 is adjacent to the second end plate. A shaft hole is defined in the second end plate for fixing the rotating shaft therein.

Furthermore, functional components, such as the connector 24, require wires to be electrically coupled to the control module 90. The socket 242 in the second end cover 20 remains stationary, and the battery 80, the control module 90, and the motor are rotatable. If the battery 80 and the control module 90 in the roller 40 are electronically coupled to the socket 242 by wires, the wires may rotate as the roller rotates 40. When the roller 40 repeatedly rotates a number of turns, the wires will also rotate the same number of turns, which is easy to cause the wires to become entangled or even damaged. On the basis of the above embodiment,

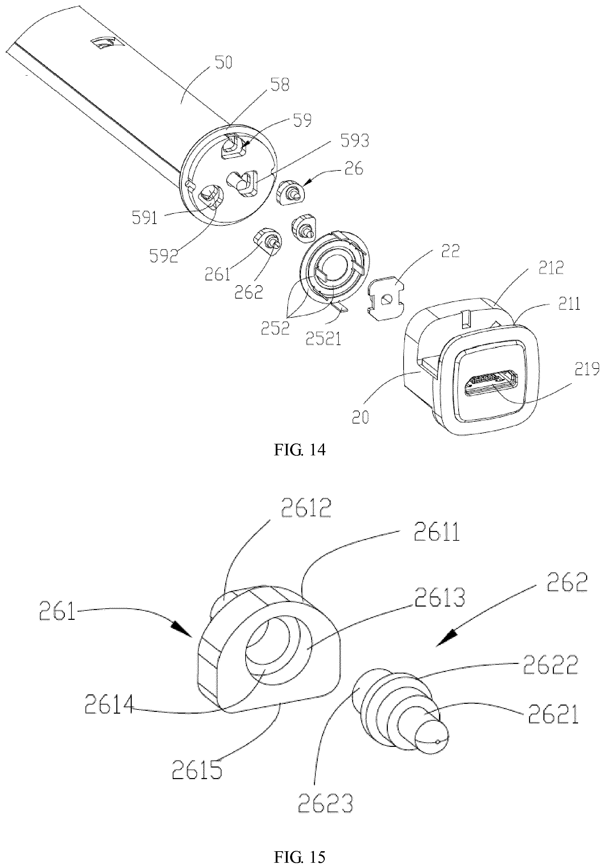

In the embodiment, electrical couplings are implemented by means of conductive rails slidably engaging with conductive terminals instead of the wires. The roller 40 is coupled to the end cover provided with functional components and rotates relative to the end cover to retract or extend the main body 200. The end cover is provided with conductive rails electrically coupling to the functional components and the roller is provided with conductive terminals corresponding to the conductive rails. The conductive terminals slidably engage with the conductive rails and slide along the conductive rails as the roller rotates. In particular, as illustrated in FIG. 13 and FIG. 14, in the embodiment, the second end cover 20 includes two conductive rails 25 and a number of conductive terminals 26 corresponding to the conductive rails 25. The motor 72 is fixed in the roller 40. The rotating shaft 71 extends through the conductive rails to be fixed to the second end cover 20. The conductive rails 25 are disposed in the second end cover 20 and surrounds the rotating shaft 71. The connector 24 is electrically coupled to the conductive rails 24, and the conductive terminals 26 are electrically coupled to the control module 90 by wires. The conductive terminals 26 are fixed to one end of the roller 40 and slidably engage with the conductive slide rails 25. The conductive terminals 26 slide along the conductive slide rails 25 as the roller 40 rotates. In the embodiment, two of the conductive terminals 26 respectively are a positive electrode and a negative electrode. It should be understood that the number of the conductive rails 25 and the number of the conductive terminals 26 is not limited to two.

The mounting wall of the second plate 212 of the second end cover 20 is provided with a recess 215. The two conductive rails 25 are annularly and coaxially formed in the recess 215. The two conductive rails includes two rail tables 251 formed at the recess 215 and conductive rings 252 disposed on surfaces of the rail tables 251. Each rail table 251 is further provided with inserting slots 2511. Each conductive ring 252 is provided with conductive leads 2521 staggered with each other. The conductive leads 2521 are inserted into the inserting slots 2511 to be electrically coupled with the connector 24.

In particular, the conductive ring 252 of the two conductive rails 25 is two metal rings with different diameters, and the conductive leads 2521 extend and bended from a edge of each conductive ring 252. The conductive leads 2521 of the two conductive rings 252 are interposed and spaced apart from each other to avoid mutual contacts. The recess 215 is a circular, and the rail tables 251 of the two conductive rails 25 are two annular steps with different diameters. The two annular steps are formed at inner peripheral wall of the recess 215 and the step in the middle of the recess is lower than the step in the outside of the recess, which may avoid an electrical connection between the two conductive rings 252. The two conductive rings 252 are respectively attached to the two steps 251.

Furthermore, the end cover is further provided with a resetting conductive ring, the roller is further provided with a conductive terminal corresponding to the resetting conductive ring. The recess is further provided with a rail for supporting the resetting conductive ring. The rail is disposed coaxially with the conductive rails and spaced from the conductive rails, as described in detail in the embodiment below. The second end cover 20 further includes a resetting conductive ring 271 and a conductive terminal 26 corresponding to the resetting conductive ring 271. The resetting conductive ring 271 is disposed coaxially with the conductive rails 25. The conductive terminal 26 is fixed to one end of the roller 40 and slidably engages with the resetting conductive ring 271. The conductive terminal 26 slides along the conductive ring 25 as the roller 40 rotates, thereby realizing a reset function. In particular, a rail table 216 is formed in an inside of the two rail tables 251 for supporting the resetting conductive ring 271. The rail table 216 and the two rail tables 251 are different in diameter and coaxially disposed. The diameters of the two rail tables 251 and the rail table 216 are sequentially reduced, and the diameters of the corresponding two conductive rings 252 and the resetting conductive ring 271 are sequentially reduced. The resetting conductive ring 271 is attached to the rail table 216 and located within the conductive rings 252.

As illustrated in FIG. 15, in the embodiment, the conductive terminals 26 refer to the three conductive terminals described above. Each conductive terminal 26 includes a seat 261 and a conductive post 262 fixed to the seat 261. The conductive post 262 includes an end portion 2623, a head portion 2621, and a flange 2622 protruding from an external circumferential surface of the conductive post 262. The end portion 2623 is connected to wires electronically coupled to the control module. An end wall of the head portion 2621 is spherical and capable of slidably contacting with the conductive rails. A diameter of the end portion 2623 is larger than that of the head portion 2621, thereby facilitating fixing the end portion 2623 and improving the sliding smoothness of the head portion 2621 sliding along the conductive rings 252.

The seat 261 includes a first ferrule 2611 and a second ferrule 2612 which formed at one end of the first ferrule 2611 and being coaxial with the first ferrule 2611. A through hole 2613 is defined in the seat 261 and extends through the first ferrule 2611 and the second ferrule 2612. The end portion 2623 of the conductive post 262 is inserted into the through hole 2613. The flange 2622 is limited in the through hole 2613. The head portion 2621 extends outside the through hole 2613. The through hole 2613 is stepped and provided with a step 2614 for engaging with the flange 2623. The three conductive terminals 26 are identical in structure.

A surface of the second end plate 58 is provided with a number of terminal slots 59 spaced from each other corresponding to the conductive terminals 26. Each terminal slot 59 includes a first portion 591 and a second portion 592 formed at a bottom wall of the first portion 591. The first portion 591 and the second portion 592 are both grooves. The second portion 592 has a diameter smaller diameter than that of the first portion 591. The seat 261 is received in the terminal slot 59. The first ferrule 2611 is received in the first portion 591, and the second ferrule 2612 is received in the second portion 592.

An external circumferential wall of the second ferrule 2612 is chamfered, and an internal circumferential wall of the second portion 592 is accordingly chamfered. An inner wall of the first portion 591 is provided with a first stop surface 593, and an external wall of the first ferrule 2611 of the seat 261 is provided with a second stop surface 2615. The first stop surface 593 engages the second stop surface 2615 to restrict a rotation of the first portion 591.

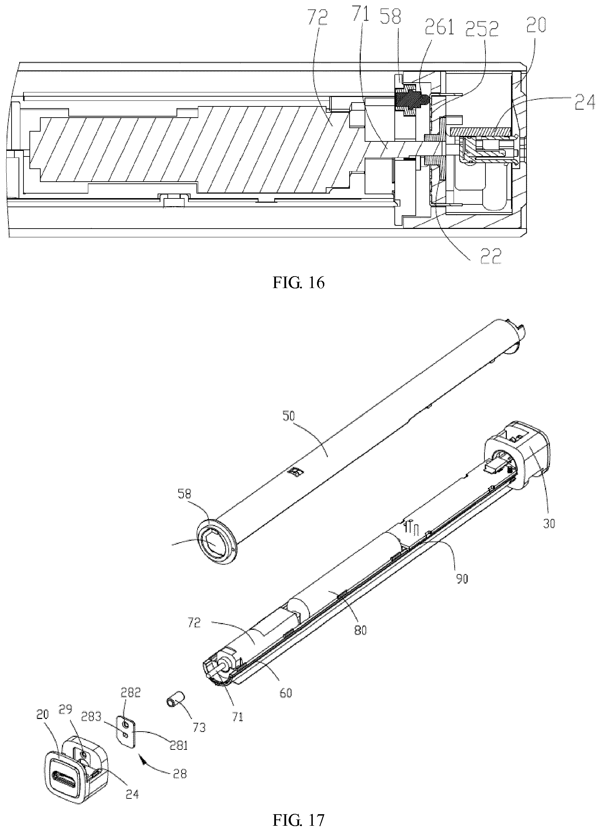

As illustrated in FIG. 16, when the second end cover 20 is attached to the second end plate 58, the rotating shaft 71 extends through the through hole 214 of the recess 215 to be limited by the limiting member 22 to restrict the rotation of the rotating shaft 71, with the first flat wall 711 engaging with the second flat wall of the limiting member 22. The head portions of the conductive terminals 26 respectively engage with the two conductive rings 252 and the resetting conductive ring 271 respectively to implement electrical couplings between the connector 24 and the control module 90. When the roller 40 drives the battery 80 and the control module 90 rotates, the second end cover may not rotate for being limited by the rotating shaft in the second end cover, and the motor rotates relative to the rotating shaft and further drives the electronic components inside the roller and the roller to rotate. At the same time, the head portions of the conductive terminals 26 slide along the conductive ring, which does not affect the rotation of the roller or the electrical couplings between the connector 24 and the control module 90, and will not cause a damage to wire.

As Illustrated in FIG. 1, in the embodiment, the driving member 70 of the flexible electronic apparatus is disposed in roller 40 which serves as the rotating shaft of the main body, and the motor of the driving member rotates as the roller rotates 40 without occupying a large space. The switch and the connector are disposed at the first end cover 30 and the second end cover 20, which improves the convenience of operation of the flexible electronic apparatus. At the same time, the slidable engagement between the conductive terminals and the conductive rails may not require wires, which avoids affecting the performance of the flexible electronic apparatus due to disorder and damage of wire.

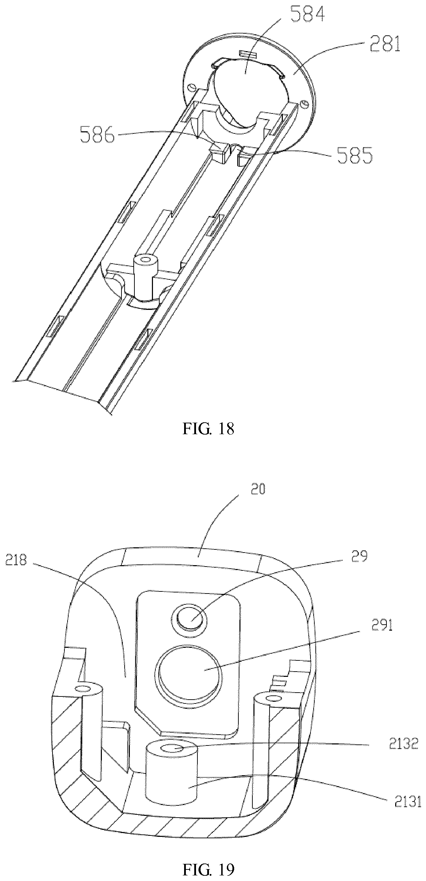

As illustrated in FIG. 17 and FIG. 18, in another embodiment, the connector 24 and the control module 90 are connected by wires rather than by conductive rails slidably engaging with the conductive terminals. The roller 40 rotates relative to the end cover as the rotating shaft rotates. The end cover is provided with functional module. The control module 90 is disposed in the roller 40. The wires are electrically coupled to the control module and the functional module. When the main body 200 is retracted, the wires are wound around the rotating shaft in a first direction. When the main body is extended, the wires are wound around the rotating shaft in a second direction opposite to the first direction.

The end plate is provided with a through hole communicated with the receiving space. one side of the end cover is provided with a through hole communicated with the cavity for the wires extending therethrough. The wires extend through the through holes to be electrically coupled to the control module.

The rotating shaft is the rotating shaft 71 of the driving member 70 that rotates relative to the motor. The rotating shaft is further sleeved with a bushing 73 for the wires winding therearound. The bushing 37 is movably sleeved on the rotating shaft 71. In particular, the bushing 73 is rotatably sleeved on the rotating shaft 71. When the motor 72 rotates relative to the rotating shaft 71, the bushing 73 rotates relative to the motor 72 at the same time. The bushing 73 is disposed between the motor 72 and the end plate.

In the embodiment, wires 245 of the USB connector 24 extends through the second end cover 20 to pre-wind around the bushing 73 and is electrically coupled to the control module 90. The bushing 73 and the motor 72 rotate relative to the shaft 71, and the wires 245 are released from the bushing 73 or wound around the bushing 73 with the rotation of the motor 72. The limiting member 28 and the second end plate 58 are both provided with a wire hole.

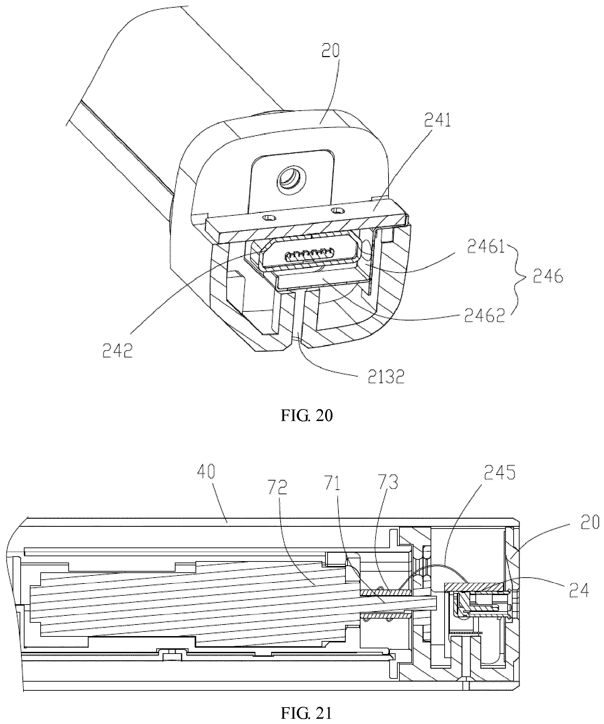

As illustrated in FIG. 21, one end of the wires 245 are coupled to the control module 90, the other end of the wires 245 are coupled to the connector 24. The wires 245 are pre-wound around the bushing 73 in a direction which is the same as a rotation direction of the roller 40 when the main body 200 is extended, and is opposite to the rotation direction of the roller 40 when the main body 200 is retracted. For example, the wires 245 are released from the bushing clockwise when the main body 200 extends out of the housing 10, and the wires 245 are wound around the bushing counterclockwise when the main body 200 retracts into the housing 10. The number of winding turns of the wire wound on the rotating shaft in a first direction is the same as the number of turns of the wire wound on the rotating shaft in a second direction. Collecting wires in such a way may achieve the best result. It should be understood, the way of collecting wires may be different. The wire is pre-wound around the bushing in a reverse direction, which may reduce the number of winding turns of the wire after the main body is extended, and further reduce the damage to the wire due to excessive number of winding turns. In another embodiment, the wires 245 may be wound directly around the rotating shaft 71 without using the bushing 73. However, the bushing is movably attached to the rotating shaft, which is helpful to prevent the wire from being too tightly wound around the rotating shaft 71 to damage the wires.

As illustrated in FIGs. 18 and 19, in particular, the second end plate 58 is provided with an opening 584 and a through hole 585, the second end cover 20 is provided with a wire hole 29 and a through hole 291, and the limiting member 28 is not provided with a sleeve and but only provided with a plate 281. The plate 281 of the limiting member 28 is provided with a through hole 282 corresponding to the wire hole 29 and a limiting through hole 283 corresponding to the through hole 291. The limiting member 28 is received in a recess (not labeled) in the cavity 213. A space is defined between the second end cover 58 and the motor for receiving the bushing 73. One end of the rotating shaft 71 of the motor 72 extends through the opening 584 to be fixed in the limiting through hole 283. The wires 245 extend through the wire hole 29 and the through hole 585 to be coupled to the control module 90.

As illustrated in FIG. 18, a pair of spaced limitation blocks 586 is formed in the first portion of the first shell 50 beside two sides of the through hole 585. A gap defined between the pair of spaced limitation blocks 586 is configured to limit the wires 245 extending into the receiving space.

As illustrated in FIG. 20, in the embodiment, a support column 2131 is formed in the cavity 213 of the second end cover 20. A through hole 2132 is axially defined in the support column 2131 and communicated with outside and the cavity 213. An resilient member 246 of the connector 24 includes a connecting portion 2461 and a resisting portion 2462 bended from and connected to the connecting portion 2461. The resisting portion 2462 is supported on the supporting post 2131 and faces the through hole 2132, which facilitates a tip extending through the through hole 2132 to resist against to implement a reset function.
the connector disposed in the second end cover 20 in this embodiment is electronically coupled to the roller 40 by the wires. Since the wires are reversely pre-wound, which may reduce the number of winding turns of the wire when the main body is extended and further reduce the damage to the wire due to excessive number of winding turns of the wire.

The above described are illustrative embodiments of the present disclosure. It should be noted that those skilled in the art may make some modifications and improvements without departing from the principle of the present disclosure. Those modifications and improvements are also considered to be within the scope of the present disclosure.

## Claims

1. A flexible electronic apparatus, comprising:
a housing;
an end cover provided with a functional component and comprising a plurality of conductive rails electrically coupled to the functional component;
a roller received in the housing and connected to the end cover, the roller provided with a plurality of conductive terminals corresponding to the conductive rails;
a main body being operable to be wound around the roller or released from the roller,
wherein the conductive terminals slide along the conductive rails as the roller rotates.

2. The flexible electronic apparatus of claim 1, wherein the roller comprises a control module disposed therein, and the conductive terminals are coupled to the control module via wires.

3. The flexible electronic apparatus of claim 2, wherein each conductive terminal comprises a seat and a conductive post fixed to the seat, wherein the conductive post comprises an end portion, a head portion, and a flange protruding from a circumferential surface of the conductive post, wherein the end portion is electronically coupled to the wires, and a distal end of the head portion slidably contacts with the conductive rail.

4. The flexible electronic apparatus of claim 3, wherein the seat comprises a through hole defined therein for receiving the end portion of the conductive terminal, the flange is limited in the through hole, and the head portion extends out of the through hole.

5. The flexible electronic apparatus of claim 4, wherein the seat comprises a first ferrule and a second ferrule which is formed at one end of the first ferrule and coaxial with the first ferrule, the through hole extends through the first ferrule and the second ferrule, an end of the roller is provided with an end plate, wherein the end plate defines a terminal slot, wherein the terminal slot comprises a first portion and a second portion formed at one end of the first portion; the seat is fixed in the terminal slot; the first ferrule is received in the first portion; the second ferrule is received in the second portion.

6. The flexible electronic apparatus of claim 5, wherein a diameter of the end portion is larger than that of the head portion, and a step is formed in the through hole of the seat to engage with the flange.

7. The flexible electronic apparatus of claim 5, wherein an external circumferential wall of the second ferrule is chamfered, and an internal circumferential wall of the second portion of the terminal slot is accordingly chamfered.

8. The flexible electronic apparatus of claim 5, wherein an inner wall of the first portion of the terminal slot is provided with a first stop surface, and an external wall of the first ferrule of the seat is provided with a second stop surface, the first stop surface engages the second stop surface to restrict a rotation of the first ferrule.

9. The flexible electronic apparatus of any one of claim 1 to claim 8, wherein a wall of the end cover is provided with a recess, the conductive rails are received in the recess; each conductive rail comprises a rail table formed in the recess and a conductive ring formed on a surface of the rail table.

10. The flexible electronic apparatus of claim 9, wherein each rail table is further provided with a plurality of inserting slot, each conductive rail is provided with a plurality conductive leads, and the conductive leads are inserted into the inserting slots to electrically couple to the functional component.

11. The flexible electronic apparatus of claim 9, wherein the end cover is further provided with a resetting conductive rail, the roller is further provided with a conductive terminal corresponding to the resetting conductive rail, a rail table is further provided in the recess for supporting the resetting conductive rail, and the rail tables are coaxially and spaced from each other.

12. The flexible electronic apparatus of claim 1, wherein the number of the conductive terminals is two, one is a positive electrode, and the other is a negative electrode.

13. The flexible electronic apparatus of any one of claim 1 to claim 8, further comprising a driving member, wherein the driving member comprises a motor and a rotating shaft which is rotatable relative to the motor, the motor is fixed to the roller, and the rotating shaft is fixed to the end cover.

14. The flexible electronic apparatus of claim 13, wherein the conductive rails surround the rotating shaft.

15. The flexible electronic apparatus of claim 13, wherein the functional component is a connector; the end cover is provided with a cavity and a port communicated with the cavity; wherein the connector comprises a circuit board and a socket fixed to the circuit board, wherein the circuit board is received in the cavity, and the socket corresponds to the port.

16. The flexible electronic apparatus of claim 15, wherein the end cover comprises a limiting member, and a limiting recess is formed in an internal wall of the cavity for receiving the limiting member therein, and the limiting member is axially restricted, and the rotating shaft is inserted into the limiting member and is axially restricted.

17. The flexible electronic apparatus of claim 16, wherein a bottom wall of the limiting recess is provided with a through hole communicated with the limiting recess; the limiting member comprises a base plate and a sleeve protruding from the base plate, the sleeve is inserted into the through hole, and the sleeve defines a limiting hole, the rotating shaft is inserted into the limiting hole.

18. The flexible electronic apparatus of claim 13, wherein the roller comprises a first shell and a second shell separable from the first shell, the first shell is attached to the second shell, and a motor of the driving member is received a receiving space cooperatively defined by the first shell and the second shell and fixed to the first shell and the second shell.
